# EUROPÄISCHE PATENTANMELDUNG

(11) **EP 2 987 576 A1**
(43) Veröffentlichungstag der Anmeldung: **24.02.2016**
(21) Anmeldenummer: 14181459.0
(22) Anmeldetag: 19.08.2014
(51) Int. Cl.: B23B 35/00, H05K 3/00, B23B 49/00

(54) **Verfahren zur Herstellung einer Bohrung und Bohrmaschine hierfür**

(71) Anmelder: Skybrain Vermögensverwaltungs GmbH, 63322 Rödermark (DE)
(72) Erfinder: Winterschladen, Markus, Dr.-Ing., 63796 Kahl (DE); Berkmann, Jochem, 64859 Eppertshausen (DE)
(74) Vertreter: Keil & Schaafhausen Patent- und Rechtsanwälte

(57) **Zusammenfassung**

Die Erfindung betrifft ein Verfahren zur Herstellung von Bohrungen (12, 13a, 13b) in einem Sandwichbauteil (6). Das Sandwichbauteil weist mehrere miteinander verbundene Lagen auf, von denen wenigstens eine Lage (9) elektrisch leitend ist und die unmittelbar benachbarten Lagen (10) nicht elektrisch leitend sind. Weiter betrifft die Erfindung eine Bohrmaschine (1) mit wenigstens einem Bohrer (5), einem mit dem Bohrer (5) verbundenen Messgerät, das über den Bohrer (5) eine Potentialdifferenz zwischen einem Bauteil (6) und einem Referenzpotential misst, einer Tiefenmesseinrichtung, mit der die Position des Bohrers (5) relativ zu einem Referenzpunkt messbar ist, und einer Rechnereinheit, die zum automatisierten Ausführen des Verfahrens eingerichtet ist.

## Beschreibung

Die Erfindung betrifft ein Verfahren zur Herstellung einer Bohrung oder einer Tiefenbohrung in einem Sandwichbauteil, das mehrere, teilweise miteinander verbundene Lagen aufweisen kann. Von diesen Lagen können eine oder mehrere Lagen elektrisch leitend sein, während die unmittelbar benachbarten Lagen bspw. nicht elektrisch leitend sind. Weiter betrifft die Erfindung eine Bohrmaschine, die zur Durchführung eines solchen Verfahrens eingerichtet ist.

In einigen Technikbereichen müssen in Sandwichbauteile Bohrungen eingebracht werden, die eine definierte Tiefe erreichen müssen. Häufig ist dabei nicht die absolute Tiefe der Bohrung relevant sondern eine relative Tiefe, deren Bezugsebene im Inneren des Materials liegt. So kann es erforderlich sein, eine bestimmte bspw. elektrisch leidende Lage unabhängig von ihrer Position innerhalb des Sandwichbauteils zu durchbohren, die nachfolgende elektrisch leitende Lage jedoch nicht mit dem Bohrwerkzeug zu berühren.

Die elektrisch leitende Lage sollte zusammen mit anderen elektrisch leitenden Lagen entweder einen Kondensatoreffekt haben oder so nach außen geführt sein, dass diese kontaktiert (mit Masse versehen) werden kann. Beispiele für derartige Sandwichbauteile sind mehrlagige Leiterplatten (Multilayer) oder Sandwichsysteme mit Aluminium-Keramik-Aufbau.

Die exakte Bearbeitung derartiger Sandwichbauteile wird teilweise dadurch erschwert, dass die genaue Position der einzelnen Lagen innerhalb des Bauteils nicht exakt bekannt ist. So können bei der Herstellung von Sandwichbauteilen beim Verpressen der einzelnen Lagen Abweichungen in der Dicke der einzelnen Lagen sowie in deren Ausrichtung innerhalb des Sandwichbauteils auftreten.

Wenn Bohrungen in ein solches Sandwichbauteil eingebracht werden sollen, bei denen eine bestimmte Lage bspw. in einem bestimmten Abstand durchbohrt wird, während die angrenzende Lage gerade nicht mehr durchbohrt werden soll, können derartige Schwankungen in der Positionierung der Lagen innerhalb des Sandwichbauteils dazu führen, dass eine bestimmte Lage fälschlicherweise nicht erreicht wird oder ungewollt durchbohrt wird. Dies kann zur Unbrauchbarkeit des gesamten Sandwichbauteils führen.

In der DE 43 40 249 A1 wird daher eine Vorrichtung beschrieben, bei welcher eine Bohrmaschine einen leitenden Bohrer (Bohrwerkzeug) aufweist, und die einzelnen Lagen eines Sandwichbauteils sowie der Bohrer mit einem Messgerät verbunden sind, so dass eine Potentialdifferenz zwischen den einzelnen Lagen über den Bohrer ermittelt werden kann, sobald dieser die elektrisch leitende Lage erreicht. Darüber hinaus ist eine Höhenmesseinrichtung für den Bohrer vorgesehen, mit der die Höhe des Bohrers relativ zu der Oberfläche des Werkstücks messerbar ist. Das Grundprinzip dieses Vorgehens ist, insbesondere wenn die Anzahl der vorhandenen elektrisch leitenden Lagen und deren ungefähre Position innerhalb des Sandwichbauteils bekannt sind, für einige Anwendungszwecke zuverlässig. Ein Nachteil dieses Systems besteht jedoch darin, dass über den Bohrer abhängig von der Bohrtiefe mehrere elektrisch leitende Lagen gleichzeitig kontaktiert werden, was in der Regel zu Messungenauigkeiten führt. Darüber hinaus ist es schwierig, mögliche Fehlsignale zu berücksichtigen.

Aufgabe der vorliegenden Erfindung ist es daher, verbesserte Verfahren für die Herstellung von Bohrungen oder Tiefenbohrungen sowie eine Bohrmaschine hierfür vorzuschlagen.

Diese Aufgabe wird mit Verfahren nach den Ansprüchen 1, 10 oder 12 sowie einer Bohrmaschine nach Anspruch 15 gelöst.

Das Verfahren nach Anspruch 1 betrifft die Herstellung einer Bohrung in einem Sandwichbauteil, das mehrere miteinander verbundene Lagen aufweist, von denen wenigstens eine Lage elektrisch leitend ist und die beiden unmittelbar benachbarten Lagen nicht elektrisch leitend sind (Mit anderen Worten ist z.B. zwischen mehreren leitenden Lagen ein Dielektrikum als nicht leitende Lage angeordnet.). Dabei ist zu Beginn des Verfahrens die exakte Position der wenigstens einen elektrisch leitenden Lage innerhalb des Sandwichbauteils unbekannt. Die Reihenfolge der Lagen innerhalb des Sandwichbauteils ist jedoch üblicherweise vorbekannt. Mit anderen Worten ist es bspw. möglich, wenn das Bauteil drei elektrisch leitende Lagen hat, dass man nachdem die erste elektrisch leitendende Lage ermittelt wurden, den nächsten elektrisch leitenden Kontakt als die zweite Lage zu identifizieren. Das Verfahren weist erfindungsgemäß folgende Schritte auf:
a) Zunächst wird eine Bohrmaschine bereitgestellt, die entweder mehrere Spindeln mit unterschiedlichen Bohrern (Bohrwerkzeugen) aufweist und/oder deren Bohrer auswechselbar sind. Die für das erfindungsgemäße Verfahren verwendeten Bohrer sind dabei elektrisch leitend und während ihres Einsatzes mit einem Messgerät verbunden, das über den jeweiligen Bohrer eine Potentialdifferenz zwischen der wenigstens einen elektrisch leitenden Lage und einem Referenzpotential, bspw. einer Erdung (Masse), misst. Darüber hinaus wird eine Tiefenmesseinrichtung bereitgestellt, mit der die Position des Bohrers relativ zu einem Referenzpunkt, bspw. der Oberfläche des Sandwichbauteils oder der maximal zurückgezogenen Stellung des Bohrers, messbar ist. Diese Tiefenmesseinrichtung ist zweckmäßigerweise mit dem Vorschub des Bohrers oder dem Z-Achsen-Messsystem (Somit ist, wenn ein Kontakt entsteht, unmittelbar/sofort die Tiefe bekannt. Die Tiefen werden dann von den einzelnen Messsystemen der Stationen abgegriffen.) verbunden.
b) In einem ersten Bearbeitungsschritt wird zunächst eine Bohrung in das Sandwichbauteil mit der Bohrmaschine eingebracht, bis sich der Bohrer (bzw. dessen Spitze) in einer Position befindet, in der die in Bohrrichtung der elektrisch leitenden Lage vorgelagerte benachbarte nicht elektrisch leitende Lage vermutet wird. Mit anderen Worten wird in dem ersten Bearbeitungsschritt eine Bohrung in das Sandwichbauteil eingebracht, bei der aufgrund der Vorkenntnisse über den Sandwichaufbau zu erwarten ist, dass sich diese noch mit Abstand zu der elektrisch leitenden Lage befindet. Werden dabei schon mehrere elektrisch leitende Lagen durchbohrt, zeichnet das Tiefenmesssystem die Positionen (Tiefen), der unterschiedlichen Lagen auf. Grundsätzlich ist es mit dem Verfahren möglich, eine Vielzahl von Lagen mit einem Bohrhub zu erkennen. Die Güte der erzeugten Signale ist von geometrischen Gegebenheiten abhängig (Durchmesser und Schneidenwinkel des Bohrers, Dicke der elektrischen Lage, Abstand der elektrischen Lagen zueinander). Ist der Abstand der elektrischen Lagen etwa zu klein, erkennt das Messsystem ggf. mehrere Lagen als eine durchgängige Lage.
c) Um die Präzision der Erfassung zu erhöhen, kann aus diesem Grund anschließend der Bohrer aus dem erzeugten Sackloch zurückgezogen und gegen einen weiteren Bohrer mit kleinerem Durchmesser ausgetauscht werden. Dies kann entweder durch einen Werkzeugwechsel erfolgen oder durch den Einsatz einer weiteren Bohrspindel, die einen Bohrer mit einem kleinerem Durchmesser trägt. Dieser kleinere Bohrer ist zumindest während seines Einsatzes wiederum mit dem Messgerät zur Messung der Potentialdifferenz verbunden.
d) Der weitere Bohrer mit kleinerem Durchmesser kann daraufhin in das zuvor durch den Bohrer mit dem größeren Durchmesser erzeugte Sackloch eingeführt werden und es kann mit dem weiteren Bohrer eine Bohrung in das Sandwichbauteil eingebracht werden, zumindest bis das Messgerät das Erreichen einer elektrisch leitenden Lage detektiert. Hierbei wird die Position des weiteren Bohrers relativ zu dem Referenzpunkt mittels der Tiefenmesseinrichtung ermittelt.
   Durch die Verwendung des kleineren Bohrers wird ein Kontakt zwischen der Innenwand des zuvor gebohrten Sacklochs und dem kleineren Bohrer vermieden, so dass das Messgerät nicht mit leitenden oder nicht leitenden Lagen in Kontakt tritt. Der erste Kontakt des kleineren Bohrers, der durch das Messgerät detektiert wird, ist damit mit großer Sicherheit die gesuchte elektrisch leitende Lage. Dieses Verfahren zeichnet sich dadurch aus, dass fehlerhafte Signale vermieden oder zumindest deutlich reduziert werden können und auch etwaige Störungen durch Kurzschluss mehrerer elektrisch leitenden Lagen über den Bohrer ausgeschlossen werden.
e) Optional wird nach dem Detektieren der gesuchten elektrisch leitenden Lage eine Durchgangsbohrung in dem Sandwichbauteil erzeugt, indem entweder mit dem weiteren (kleineren) Bohrer in dem Sackloch weitergebohrt wird oder ein erneuter Werkzeug- oder Spindelwechsel stattfindet, so dass die Durchgangsbohrung bspw. mit dem ersten (größeren) Bohrer erfolgen kann. Dieser muss nicht mit dem Messgerät verbunden sein oder elektrisch leitend sein, falls ausschließlich die Durchgangsbohrung hergestellt werden soll. Auch bei diesem Durchbohren können vorzugsweise die elektrisch leitenden Lagen aufgezeichnet werden.

Grundsätzlich ist es bei mehreren elektrisch leitenden Lagen innerhalb eines Bauteils möglich, zumindest einige oder jede dieser elektrisch leitenden Lagen nacheinander einzeln mit dem obigen Verfahren in ihrer Position zu erfassen. Bei entsprechender Signalqualität ist es auch möglich, mehrere elektrische Lagen während eines Bohrvorgangs in guter Qualität aufzunehmen. Erst wenn nacheinander einige oder alle Lagen hinsichtlich ihrer Position erfasst sind, wird dann ggf. die Durchgangsbohrung erzeugt. Mit anderen Worten werden die Schritte b), c) und d) optional für jede elektrisch leitende Lage einzeln durchgeführt, besonders dann, wenn die Präzision der Tiefenbohrung maximiert werden soll.

Bei dem Aufzeichnen der Positionen (Tiefen) durch das Tiefenmesssystem in Schritt b) werden genau genommen die absoluten Z-Werte der einzelnen Stationen aufgenommen. Um eine saubere Null-Ebene bzw. Bezugsebene zu haben, wird vorzugsweise der jeweilige Laserschaltpunkt bei der Werkzeugvermessung verwendet. Wenn man das nicht macht, dann kann man nach einem Werkzeugwechsel den Bezug verlieren, wenn die Werkzeuge z.B. jeweils unterschiedlich weit aus der Spindel hervorstehen. Die Qualität der Tiefengenauigkeit ist auch von der Qualität der Lasermessung abhängig.

Die optionalen Schritte c) und d) dienen dazu, die Signalqualität zu erhöhen. Erfahrungsgemäß ist es möglich, zwei, manchmal auch drei oder mehr Lagen in einem Bohrdurchgang (One Shot) zu erfassen. Je mehr elektrische Lagen in einem Bohrvorgang durchbohrt werden, desto schlechter wird das Signal. Mit anderen Worten: Die Streuung der Signale wir exponentiell grösser mit jeder zusätzlichen detektierten Lage im Bohrdurchgang. Das bedeutet für die Erfindung aber auch, dass prinzipiell auch die Lagen in "One Shot" aufgezeichnet werden können. Schritte b) und c) werden also optional durchgeführt, um die Tiefenqualität zu verbessern.

Unter einem Sandwichbauteil wird im Folgenden insbesondere ein plattenförmiges Bauteil verstanden, dessen Länge und Breite (Ausdehnung in XY-Richtung) in der Regel deutlich größer als seine Dicke (Z-Richtung) ist. Auch die einzelnen Lagen des Sandwichbauteils erstrecken sich im Wesentlichen in der XY-Ebene bei einer geringen Höhe in Z-Richtung. Das Bohren erfolgt dabei typischerweise senkrecht zu der XY-Ebene, d.h. in Z-Richtung. Üblicherweise ist die Dicke von nicht leitenden Lagen größer als die von elektrisch leitenden Lagen, bei denen es sich z.B. um dünne Folien handeln kann. In der Regel sind die nicht leitenden Lagen Prepregs oder aber Kleber oder Harz.

Nach einer bevorzugten Ausführungsform ist die wenigstens eine elektrisch leitende Lage mit dem Messgerät verbunden. Dies kann bspw. über einen Kontaktbereich an einem der Seitenränder des Sandwichbauteils erfolgen. Alternativ oder zusätzlich hierzu kann zur Messung der Potentialdifferenz durch das Messgerät der Kondensatoreffekt genutzt werden, wenn mehrere elektrisch leitende Lagen vorgesehen sind. Das Messgerät ist dann dazu eingerichtet, eine durch den Kondensatoreffekt erzeugte Potentialdifferenz zwischen dem Referenzpotential, bspw. einer Erdung, und dem Potential der elektrisch leitenden Lagen zu messen.

Wenn in Schritt e) die optionale Durchgangsbohrung nicht mit dem weiteren (kleineren) Bohrer erzeugt wird, kann nach einer bevorzugten Ausführungsform des erfindungsgemäßen Verfahrens die Durchgangsbohrung mit einem Bohrer erzeugt werden, dessen Außendurchmesser größer als der des weiteren (kleineren) Bohrers ist. Auf diese Weise ist es möglich, dass auch in Schritt e) des erfindungsgemäßen Verfahrens nochmals die Position des Bohrers relativ zu dem Referenzpunkt mittels der Tiefenmesseinrichtung bestimmt wird, wenn das Messgerät erneut das Erreichen der elektrisch leitenden Lage nachfolgend der in Schritt b) erreichten Position detektiert. Hierdurch ist es möglich, den in Schritt d) gemessenen Wert nochmals zu überprüfen, wodurch die Genauigkeit des Verfahrens weiter steigt. Insbesondere wenn zuvor bereits die Position einiger oder aller elektrisch leitenden Lagen bestimmt wurde, kann die Durchgangsbohrung eingebracht werden, ohne dass der Bohrer an jeder elektrisch leitenden Lage anhält.

Nach einer besonders bevorzugten Ausführungsform der Erfindung stoppt bei einem Sandwichbauteil mit mehreren elektrisch leitenden Lagen der Bohrer in Schritt b) des Verfahrens bei jedem über das Messgerät detektierten Kontakt. Die elektrisch leitende Lage ist dann nicht vollständig durchbohrt sondern der Bohrer hat allenfalls eine kleine Vertiefung in der elektrisch leitenden Lage vorgesehen. Um das Bohrloch und die Kontaktfläche zu der elektrisch leitenden Lage zu reinigen, kann der Bohrer kurzzeitig an dieser Stelle verharren und wird vorzugsweise danach ganz oder teilweise aus dem Bohrloch zurückgezogen. Durch erneutes Weiterbohren wird wiederum an der elektrisch leitenden Lage ein Kontakt durch das Messgerät detektiert. Wenn bei dem erneuten Weiterbohren alle bis zum Erreichen der Position, an der der Bohrer zuletzt gestoppt hat, detektierten Kontakte des Messgeräts ignoriert werden, kann die Position der elektrisch leitenden Lage sehr genau und fehlerfrei bestimmt werden. Mit anderen Worten wird bei dieser Ausführungsform die Position einer elektrisch leitenden Lage zumindest zweimal hintereinander bestimmt. Die so ermittelten Werte können verglichen und/oder auf Plausibilität geprüft werden.

Das Verfahren lässt sich in besonders vorteilhafter Weise mit einem Bohrer durchführen, wie er in der noch unveröffentlichten deutschen Patentanmeldung 10 2013 004 679 beschrieben ist. Dieser Bohrer ist mit Ausnahme der Spitze mit einer nicht leitenden Beschichtung versehen bzw. nur die Spitze und die Seele sind elektrisch leitend, so dass etwaige Kontakte an der Innenwand des Bohrlochs nicht von dem Messgerät detektiert werden können. Die Verwendung eines solchen Bohrers steigert damit die Genauigkeit des Verfahrens.

Die Genauigkeit des erfindungsgemäßen Verfahrens kann auch dadurch weiter gesteigert werden, dass mehrere zueinander versetzte Bohrungen bzw. Durchgangsbohrungen in das Sandwichbauteil eingebracht werden, wobei die oben genannten Maßnahmen zumindest bei mehreren der Bohrungen durchgeführt werden. Auf diese Weise lässt sich die an einer Stelle detektierte Position einer elektrisch leitenden Lage überprüfen.

Um die Genauigkeit des Verfahrens weiter zu verbessern, können die mittels der Tiefenmesseinrichtung ermittelten Positionen des Bohrers relativ zu dem Referenzpunkt auf Plausibilität überprüft und ggf. rechnerisch korrigiert werden. Dies kann bspw. durch eine stochastische Auswertung, eine Häufigkeitsverteilung und/oder einem Filtern bestimmter Werte erfolgen. Hierbei kann berücksichtigt werden, dass die Position einer Lage innerhalb des Sandwichbauteils zwar geringfügig variieren und/oder von einem Idealwert abweichen kann, dass jedoch z.B. sprunghafte Verwerfungen nicht auftreten.

Beim Einbringen einer Durchgangsbohrung mit im Vergleich zur Dicke des Sandwichbauteils kleinem Durchmesser, kommt es in der Regel zu einem Verlauf des Bohrers. In diesem Fall werden zur Erzeugung von Durchgangslöchern die Sandwichbauteile von beiden Seiten gebohrt, jeweils bis zu Hälfte (sog. Flip-Drilling). Beim Einbringen der Bohrung von der Vorderseite und von der Rückseite kann das erfindungsgemäße Verfahren ebenfalls eingesetzt werden. Die Tiefenbohrung(en) der Vorderseite des Sandwichbauteils wird dabei so ausgeführt, dass die Z-Achse innerhalb einer der mittleren Lagen stoppt. Bei der Einbringung der Bohrung von der Rückseite wird diese Lage nun von ihrer Rückseite erneut erfasst. Da die Dicke der einzelnen Lage in guter Qualität bekannt ist, können nun die ermittelten Daten beider Bohrvorgänge miteinander verrechnet werden, um auch tiefe Referenzlagen zu erfassen. Die beiden Bohrvorgänge können dabei jeweils "One Shot" oder optional zur Steigerung der Genauigkeit mit den Schritten b) und/oder c) zusätzlich durchgeführt werden.

In den meisten Anwendungsfällen, bspw. bei Leiterplatten, ist bei mehreren elektrisch leitenden Lagen deren Anzahl vorbekannt. Auf diese Weise ist es möglich, die Position des Bohrers relativ zu dem Referenzpunkt mittels der Tiefenmesseinrichtung immer dann zu bestimmen, wenn das Messgerät das Erreichen einer elektrisch leitenden Lage detektiert. Zusammen mit dem Wissen über die Anzahl der elektrisch leitenden Lagen kann die Suche nach einer bestimmten elektrisch leitenden Lage auf diese Weise erleichtert werden bzw. die Genauigkeit der Positionsbestimmung verbessert werden. Ein besonders bevorzugter Anwendungsfall für das zuvor beschriebene Verfahren ist die Herstellung von mehreren Durchgangsbohrungen in einem Sandwichbauteil, wobei dieser Vorgang dazu genutzt wird, die genaue Position einer oder mehrerer elektrisch leitender Lagen innerhalb des Sandwichbauteils zu bestimmen, die für nachfolgende Bearbeitungsschritte benötigt wird. Manche Sandwichbauteile werden, nachdem sie mit einer Vielzahl von Durchgangsbohrungen versehen sind, einer Behandlung unterzogen, bei der sich eine dünne Hülse oder Schicht aus einem elektrisch leitfähigen Material auf der Innenseite des Bohrlochs ablagert. Um bspw. Schaltungen mit dem Sandwichbauteil zu realisieren, müssen diese Hülsen oder Ablagerungen definiert aufgebohrt werden, so dass die Hülse oder Ablagerung nur in definierten Zonen innerhalb des Bohrlochs noch vorhanden ist. Dies erfolgt über sog. Tiefenbohrungen, bei denen ein Bohrer nur bis zu einer bestimmten Position in das Bohrloch eindringt und dabei die Hülse oder Beschichtung entfernt und so exakt stoppt, dass in anderen Bereichen die Hülse oder Beschichtung definiert bestehen bleibt. Auf diese Weise ist es möglich, mehrere elektrisch leitende Lagen in dem Sandwichaufbau gezielt miteinander zu verbinden.

Ein eigenständiger Erfindungsgedanke betrifft unabhängig von den zuvor beschriebenen Maßnahmen ein Verfahren zur Herstellung einer Tiefenbohrung in einem Sandwichbauteil, das mehrere miteinander verbundene Lagen aufweist, von denen wenigstens eine Lage elektrisch leitend ist und die unmittelbar benachbarten Lagen nicht elektrisch leitend sind. Dabei ist die exakte Position der elektrisch leitenden Lage innerhalb des Sandwichbauteils zunächst unbekannt. Aus diesem Grund ist die Herstellung einer Tiefenbohrung, bei der eine exakte Position innerhalb des Sandwichbauteils erreicht werden soll, indem bspw. eine elektrisch leitende Lage gerade erreicht, aber nicht durchbohrt werden soll, nicht mit ausreichender Präzision möglich. Hierzu sieht das erfindungsgemäße Verfahren vor, dass zunächst die Position wenigstens einer elektrisch leitenden Lage innerhalb des Sandwichbauteils an mehreren voneinander beabstandeten Stellen ermittelt wird. Aus diesen Positionsdaten wird in einem darauffolgenden Schritt ein virtuelles dreidimensionales Modell des Sandwichbauteils einschließlich seiner Lagen, zumindest der wenigstens einen elektrisch leitenden Lage, erzeugt. Auf Basis dieses dreidimensionalen Modells wird dann die Tiefenbohrung erzeugt. Es ist dabei nicht erforderlich, an jeder Stelle, an der eine Tiefenbohrung eingebracht werden soll, zuvor die exakte Position einer elektrisch leitenden Lage innerhalb des Sandwichbauteils individuell zu erfassen. Vielmehr ist es ausreichend, wenn das dreidimensionale Modell einen errechneten Positionswert der elektrisch leitenden Lage für jede Stelle, an der eine Tiefenbohrung eingebracht werden soll, bestimmt.

Für das Erstellen des virtuellen dreidimensionalen Modells des Sandwichbauteils können dabei neben den gemessenen Positionsdaten der elektrisch leitenden Lagen innerhalb des Sandwichbauteils auch Informationen über die Anzahl und Verteilung der einzelnen Lagen innerhalb des Sandwichbauteils genutzt werden. Weiter können Filter oder mathematische Verfahren Verwendung finden, um gemessene Positionen einer elektrisch leitenden Lage innerhalb des Bauteils auf Plausibilität zu prüfen. Auf diese Weise lassen sich Fehlmessungen oder sehr unwahrscheinliche Messstellen für die Erstellung des dreidimensionalen Modells ignorieren. Die Ermittlung der Position der wenigstens einen elektrisch leitenden Lage innerhalb des Sandwichbauteils an mehreren voneinander beabstandeten Stellen kann auf unterschiedliche Weise erfolgen. So ist bspw. möglich, dies mit dem zuvor beschriebenen Verfahren während des Einbringens von Durchgangbohrungen vorzunehmen. Alternativ oder zusätzlich hierzu können die Positionsdaten, auch wie in der noch nicht veröffentlichten deutschen Patentanmeldung 10 2013 004 679 beschrieben, erzeugt werden.

Das Herstellen einer Tiefenbohrung, bei der eine exakte Bohrtiefe innerhalb eines Sandwichbauteils erreicht werden soll, ist selbst bei bekannter Position der zu erreichenden Bohrtiefe innerhalb des Sandwichbauteils in der Praxis mit Schwierigkeiten verbunden, weil die Sandwichbauteile für die Bearbeitung meist auf einem Träger liegen, auf dem wiederum eine Unterlagsschicht (Backup) liegt, auf der das Sandwichbauteil positioniert wird, auf dem wiederum eine oder mehrere Decklagen (Entry) aufgebracht werden. Durch geringfügige Unebenheiten innerhalb dieses Aufbaus kann es bei dem Einbringen der Tiefenbohrung selbst bei genauer Kenntnis über den Lagenaufbau innerhalb des Sandwichbauteils selbst zu Fehlern kommen.

Ein weiterer Kerngedanke der vorliegenden Erfindung begegnet unabhängig von den zuvor genannten Maßnahmen diesem Problem. Hierzu ist erfindungsgemäß vorgesehen, dass wenigstens eine untere Schicht auf einen Tisch einer Bohrmaschine aufgelegt wird, danach das Sandwichbauteil auf die untere Schicht aufgelegt wird und anschließend wenigstens eine obere Schicht auf das Sandwichbauteil aufgelegt wird. Der Abstand wenigstens eines Referenzpunktes auf der oberen Schicht zu der Oberfläche des Tisches wird anschließend gemessen. Hieraus wird die Tiefe der Tiefenbohrung relativ zu dem Referenzpunkt auf der oberen Schicht errechnet und die Tiefenbohrung bis zu dieser errechneten Tiefe in das Sandwichbauteil eingebracht.

Die Abstandsmessung erfolgt vorzugsweise dadurch, dass die obere Schicht elektrisch leitend ist und beim Absenken des Bohrers auf die obere Schicht ein Kontakt detektiert wird, wobei gleichzeitig über eine andere Messeinrichtung die Höhe der Bohrerspitze über der Oberfläche des Tisches gemessen wird. Für dieses Verfahren ist es erforderlich, zumindest die zu erwartende Dicke der oberen Schicht zu kennen, so dass diese beim Errechnen der Tiefe der Tiefenbohrung mit berücksichtigt werden kann.

Nach einer besonders bevorzugten Ausführungsform der Erfindung wird nicht nur an einem Referenzpunkt der Abstand zwischen der oberen Schicht und der Oberfläche des Tisches gemessen, sondern es wird eine Vielzahl von Referenzpunkten gemessen. Auf diese Weise kann eine Topografie des auf dem Tisch der Bohrmaschine liegenden Stapels aus unterer Schicht, Sandwichbauteil und oberer Schicht errechnet werden, die für die Bestimmung der Tiefe der Tiefenbohrung berücksichtigt werden kann. Vorzugsweise wird an jeder Stelle, an der eine Tiefenbohrung vorgesehen werden soll, eine solche Messung vorgenommen. Bei der Errechnung der Tiefe der Tiefenbohrung kann auch das Verhältnis zwischen dem gemessenen Abstand zwischen dem Referenzpunkt auf der oberen Schicht und der Oberfläche des Tisches zudem über bekannte Nennwerte der Dicken der einzelnen Schichten berücksichtigt werden.

Eine weitere Verfeinerung dieses Verfahrens sieht vor, dass zunächst vor dem Aufbringen des Sandwichbauteils nur die wenigstens eine untere Schicht und die wenigstens eine obere Schicht aufeinander auf den Tisch der Bohrmaschine aufgebracht werden. Anschließend wird wenigstens ein Referenzpunkt auf der Oberseite der oberen Schicht wie zuvor beschrieben vermessen. Vorzugsweise wird wieder der Abstand mehrerer Referenzpunkte auf der oberen Schicht zu der Oberfläche des Tisches gemessen. Anschließend wird das Sandwichbauteil zwischen der unteren Schicht und der oberen Schicht positioniert und es wird erneut der Abstand wenigstens eines Referenzpunktes auf der oberen Schicht zu der Oberfläche des Tisches gemessen. Die Tiefe der Tiefenbohrung relativ zu dem Referenzpunkt auf der oberen Schicht kann dann unter Berücksichtigung der Messergebnisse vor und nach dem Einlegen des Sandwichbauteils errechnet werden.

Eine Weiterbildung des Erfindungsgedankens sieht vor, dass das Sandwichbauteil zunächst mit der beim Bohren oberen Seite nach unten gerichtet zwischen die wenigstens eine untere Schicht und die wenigstens eine obere Schicht eingelegt und die Messung wie oben beschrieben vorgenommen wird. Anschließend wird das Sandwichbauteil in die richtige Lage umgedreht, so dass die beim Bohren obere Seite nach oben weist. Dann kann eine erneute Messung der Abstände vorgenommen werden. Aus diesen Werten lässt sich dann die Tiefe der Tiefenbohrung relativ zu einem Referenzpunkt auf der oberen Schicht errechnen.

Für dieses Verfahren ist es erforderlich, die Tiefe der Tiefenbohrung relativ zu der Oberfläche des Sandwichbauteils mit ausreichender Genauigkeit zu kennen. Dies kann mit einem der anderen erfindungsgemäßen Verfahren wie zuvor beschrieben ermittelt werden.

Ein weiterer Aspekt der Erfindung betrifft eine Bohrmaschine mit wenigstens einem Bohrer, einem mit dem Bohrer verbundenen Messgerät, das über dem Bohrer eine Potentialdifferenz zwischen einem Bauteil, bspw. einer Lage eines Sandwischbauteils, und einem Referenzpotential misst, einer Tiefenmesseinrichtung, mit der die Position des Bohrers relativ zu einem Referenzpunkt messbar ist, und mit einer Rechnereinheit, die zum automatisierten Ausführen eines der zuvor genannten Verfahren eingerichtet ist. Die Rechnereinheit kann bspw. auch mittels abgespeicherter oder eingebbarer Datensätze sowie unter Berücksichtigung der Messwerte des Messgeräts und/oder der Tiefenmesseinrichtung die zuvor genannten Berechnungen vornehmen.

Die Erfindung wird nachfolgend auch unter Bezugnahme auf die beigefügte Zeichnung näher erläutert. Es zeigen schematisch:
- Figur 1: in Seitenansicht eine erfindungsgemäße Bohrmaschine mit einem Sandwichaufbau (in Schnittansicht) mit stark vergrößerten Unregelmäßigkeiten,
- Figur 2: in Schnittansicht den Schichtaufbau bei der Bearbeitung eines Sandwischbauteils,
- Figuren 3a, 3b: vereinfacht zwei Verfahrensschritte zur Vorbereitung von Tiefenbohrungen, und
- Figur 4: in Schnittansicht verschiedene Arten der Bearbeitung eines Sandwichbauteils.

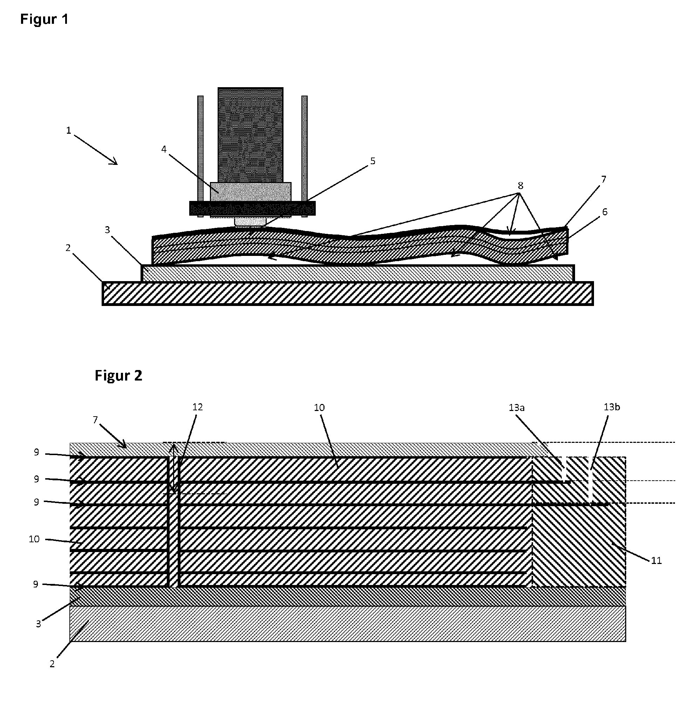

In Figur 1 ist eine Bohrmaschine 1 dargestellt, die einen ebenen Tisch 2 und eine darauf vorgesehene Unterlagsschicht (Backup) 3 aufweist. Weiter weist die Bohrmaschine 1 wenigstens eine Bohrspindel 4 mit einem Bohrer (Bohrwerkzeug) 5 auf. Auf der Unterlagsschicht 3 ist ein Sandwichbauteil 6 aufgelegt, das in der Darstellung der Figur 1 übertrieben stark gewellt ist. Üblicherweise handelt es sich bei dem Sandwichbauteil 6 um ein im Wesentlichen plattenförmiges Bauteil, das Unebenheiten von je nach Plattendicke zum Teil mehrere Zehntel Millimeter aufweist. Auf dem Sandwichbauteil 6 wiederum liegt eine Deckschicht (Entry) 7. Abweichend von der Darstellung in Figur 1 kann zwischen dem Tisch 2 und der Unterlagsschicht 3 bspw. ein Träger oder dergleichen vorgesehen sein. Weiter ist es möglich, dass die Deckschicht mehrlagig ausgebildet, bspw. mit einer elektrisch leitenden obersten Schicht. In der Darstellung der Figur 1 ist die Breite des Bauteils bspw. die X-Richtung und die Dicke des Bauteils bspw. die Z-Richtung.

Wie aus der vergrößerten Darstellung der Figur 2 ersichtlich ist, ist das Sandwichbauteil 6 aus mehreren Lagen aufgebaut, die bspw. miteinander verpresst oder verklebt sein können. In der dargestellten Ausführungsform weist das Sandwichbauteil 6 eine Vielzahl von elektrisch leitenden Lagen 9 sowie zwischen diesen vorgesehenen Lagen 10 auf, die nicht elektrisch leitend sind und damit die Lagen 9 voneinander isolieren. Auf der in Figur 2 rechten Seite ist ein Kontaktbereich 11 angedeutet, der bspw. einen Randbereich des Sandwichbauteils 6 sein kann. Bezugsziffer 12 deutet in Figur 2 eine Durchgangsbohrung an, die sich durch sämtliche Schichten des Sandwichbauteils 6 erstreckt. Weiter sind in dem Kontaktbereich 1 zwei Sacklöcher 13a, 13b ausgebildet, die zur Verbindung einzelner elektrisch leitender Lagen 9 mit einem Messgerät der Bohrmaschine 1 dienen können. Das Sackloch 13a erstreckt sich dabei von der Oberfläche des Sandwichbauteils 6 bis auf die Ebene der zweiten elektrisch leitenden Lage, während das Sackloch 13b sich bis zu der dritten elektrisch leitenden Lage erstreckt.

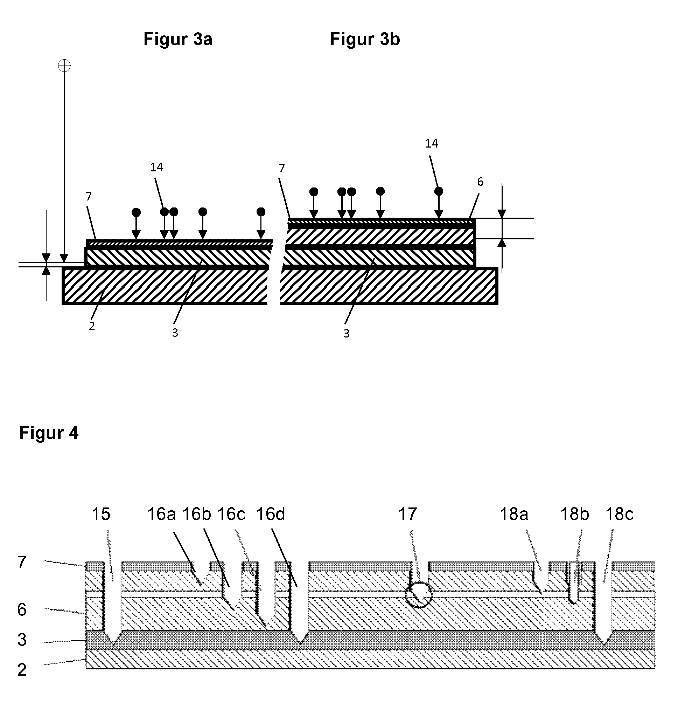

In den Figuren 3a und 3b sind zwei Verfahrensschritte zur Vorbereitung der Herstellung von Tiefenbohrungen angedeutet. Hierzu wird nach Figur 3a zunächst auf den Tisch die Unterlagsschicht 3 und unmittelbar darauf die Deckschicht 7 aufgebracht. Mit diesem Schichtaufbau misst die Spitze des Bohrers wie durch die Pfeile angedeutet die Höhe dieses Schichtaufbaus über der Oberfläche des Tisches 2 an verschiedenen Referenzpunkten 14 auf der Oberfläche der Deckschicht 7, bspw. den Stellen, an denen nachfolgend Tiefenbohrungen eingebracht werden sollen. In einem nachfolgenden Verfahrensschritt wird gemäß Figur 3b das Sandwichbauteil 6 zwischen die Unterlagsschicht 3 und die Deckschicht 7 gelegt. Daraufhin wird erneut mit der Spitze des Bohrers an den Referenzpunkten 14 auf der Oberseite der Deckschicht 7 der Abstand zu der Oberseite des Tisches 2 gemessen. Aus einem Abgleich der nach den Figuren 3a und 3b gewonnen Messwerte kann für jeden Referenzpunkt 14, der bspw. dem Ort einer einzubringenden Tiefenbohrung entspricht, bei bekannter Dicke der Deckschicht und bei bekannter Position der elektrisch leitenden Lagen innerhalb des Sandwichbauteils 6 eine Tiefenbohrung so eingebracht werden, dass der Bohrer definiert kurz vor oder kurz nach einer der elektrisch leitenden Lagen 9 angehalten werden kann.

Figur 4 zeigt verschieden Arten der Bearbeitung eines Sandwichbauteils in Schnittansicht. Dargestellt sind das Bohren, das Pulsbohren (Pecken), die Grenze des Systems Bohren/Pulsbohren sowie das erfindungsgemäße Verfahren bei Verwendung mehrerer Bohrer mit unterschiedlichen Durchmessern.

In dem in Figur 4 schematisch dargestellten Sandwichbauteil 6 sind zwischen der Decklage (Entry) 7 und der Backupschicht 3 zwei schraffiert dargestellte dickere nicht leitende Lagen und zwei durch ein dünneres Dielektrikum (weiß) getrennte leitende Lagen (schwarze Linien) vorgesehen.

In Figur 4 ist links eine mit 15 bezeichnete Bohrung eingebracht, die bspw. bereits den gewünschten Nenndurchmesser aufweist. Das Bohrwerkzeug (nicht gezeigt) kann während des Einbringens der Bohrung wie oben beschrieben die Position der elektrisch leitenden Lage innerhalb des Sandwichbauteils ermitteln, wenn ein elektrischer Kontakt zwischen dem Bohrwerkzeug und der elektrisch leitenden Lage festgestellt wird.

Statt eines einzigen Bohrvorgangs kann zur Bestimmung der Position einer oder mehrerer Lagen in dem Bauteil 6 auch ein als Pulsbohren oder Pecken bezeichnetes Verfahren eingesetzt werden, bei dem mehrere Bohrungen 16a, 16b, 16c und 16d mit unterschiedlicher Tiefe in das Bauteil 6 eingebracht werden. Abweichend von der Darstellung in Figur 4 werden die Bohrungen 16a, 16b, 16c und 16d allerdings statt versetzt zueinander an derselben Stelle eingebracht, d.h. das Bohrwerkzeug dringt an derselben Stelle mehrmals hintereinander mit jeweils steigender Tiefe in das Bauteil 6 ein. Zur vereinfachten Erklärung des Verfahrens sind die Bohrungen versetzt dargestellt. Dabei können bei geeigneter Prozessführung (Stop innerhalb einer elektrisch leitenden Lage) bei jedem Eindringen die bereits zuvor erfassten Kontakte verifiziert werden.

Die Bohrung 17 in Figur 4 zeigt die technischen Grenzen der Genauigkeit der Positionsbestimmung beim Bohren oder Pecken auf. Die Güte der erzeugten Signale ist von geometrischen Gegebenheiten abhängig wie dem Durchmesser und dem Schneidenwinkel des Bohrwerkzeugs, der Dicke der elektrischen Lage und dem Abstand der elektrischen Lagen zueinander. Ist der Abstand der elektrischen Lagen etwa zu klein, erkennt das Messsystem ggf. mehrere Lagen als eine durchgängige Lage. Dies ist bei der Bohrung 17 in Figur 4 der Fall, da die Spitze des Bohrwerkzeugs gleichzeitig mit beiden elektrisch leitenden Lagen in Kontakt ist und diese somit kurzschließt.

Ein Verfahren, bei dem die Position elektrisch leitender Lagen mit hoher Genauigkeit in dem Bauteil 6 bestimmt werden kann, ist durch die Bohrungen 18a, 18b und 18c angedeutet. Zunächst wird mit einem ersten (im Durchmesser größeren) Bohrwerkzeug die Bohrung 18a erzeugt. Sobald die Spitze des Bohrwerkzeugs mit der in Figur 4 oberen elektrisch leitenden Lage in Kontakt kommt, stoppt der Vorschub des Bohrwerkzeugs. Das Bohrwerkzeug wird dann aus dem Sackloch 18a zurückgezogen und gegen ein anderes Bohrwerkzeug ausgetauscht, das einen kleineren Durchmesser hat. Mit diesem (kleineren) Bohrwerkzeug wird erneut in das selbe Bohrloch gebohrt, wobei die Wand des zuvor erzeugten Bohrlochs 18a nicht mit dem bohrwerkzeug in Kontakt kommt. Damit können vorherige Kontakte oder sonstige Störfaktoren eliminiert werden und der erste Kontakt des (kleineren) Bohrwerkzeugs ist dann die leitende Lage. Bezugszeichen 18b zeigt das durch das (kleinere) Bohrwerkzeug erzeugte Sackloch, das nur aus Gründen der Übersichtlichkeit neben dem (eigentlich ortsgleichen) Bohrloch 18a dargestellt ist. Mit 18c ist eine Durchgangsbohrung gekennzeichnet, die z.B. wieder mit dem ersten (größeren) Bohrwerkzeug erzeugt wird, nachdem mit dem zweiten (kleineren) Bohrwerkzeug die Position der elektrisch leitenden Lagen verifiziert ist. Auch beim Einbringen der Bohrung 18c, die wiederum nur aus Gründen der Übersichtlichkeit versetzt zu den Bohrungen 18a und 18b dargestellt ist, kann die Position der elektrisch leitenden Lagen erneut verifiziert werden.

### Bezugszeichenliste:

- 1: Bohrmaschine
- 2: Tisch
- 3: Unterlagsschicht (Backup)
- 4: Bohrspindel
- 5: Bohrer (Werkzeug)
- 6: Sandwichbauteil
- 7: Deckschicht (Entry)
- 8: Lufteinschluss
- 9: elektrisch leitende Lage
- 10: nicht elektrisch leitende Lage
- 11: Kontaktbereich
- 12: Durchgangsbohrung
- 13a, b: Sackloch
- 14: Referenzpunkt
- 15: Bohrung
- 16a-d: Bohrung
- 17: Bohrung
- 18a-c: Bohrung

## Patentansprüche

1. Verfahren zur Herstellung einer Bohrung in einem Sandwichbauteil (6), das mehrere miteinander verbundene Lagen (9, 10) aufweist, von denen wenigstens eine Lage (9) elektrisch leitend ist und die unmittelbar benachbarten Lagen (10) nicht elektrisch leitend sind, wobei die exakte Position der elektrisch leitenden Lage (9) innerhalb des Sandwichbauteil (6) unbekannt ist, mit folgenden Schritten:
a) Vorsehen einer Bohrmaschine (1), deren Bohrer (5) elektrisch leitend ist, eines mit dem Bohrer (5) verbundenen Messgeräts, das über den Bohrer (5) eine Potentialdifferenz zwischen der wenigstens einen elektrisch leitenden Lage (9) und einem Referenzpotential misst, und einer Tiefenmesseinrichtung, mit der die Position des Bohrers (5) relativ zu einem Referenzpunkt messbar ist,
b) Einbringen einer Bohrung (13a, 13b; 18a) in das Sandwichbauteil (6) mit der Bohrmaschine (1) bis zu der vermuteten Position der der elektrisch leitenden Lage (9) in Bohrrichtung vorgelagerten benachbarten nicht elektrisch leitenden Lage (10),
c) optional Zurückziehen des Bohrers (5) und Austausch gegen einen weiteren Bohrer mit kleinerem Außendurchmesser, wobei der kleinere Bohrer wiederum mit dem Messgerät verbunden wird,
d) optional Einführen des weiteren Bohrers in das in Schritt b) erzeugte Sackloch (13a, 13b; 18a) und Einbringen einer Bohrung (18b) mit dem weiteren Bohrer zumindest bis das Messgerät das Erreichen einer elektrisch leitenden Lage (9) detektiert und Ermittlung der Position des weiteren Bohrers relativ zu dem Referenzpunkt mittels der Tiefenmesseinrichtung,
e) ggf. Herstellen einer Durchgangsbohrung (12; 18c) in dem in Schritt d) erzeugten Sackloch (13a, 13b; 18a, 18b).

2. Verfahren nach Anspruch 1, **dadurch gekennzeichnet, dass** die wenigstens eine elektrisch leitende Lage (9) mit dem Messgerät verbunden ist.

3. Verfahren nach Anspruch 1 oder 2, **dadurch gekennzeichnet, dass** mehrere elektrisch leitende Lagen (9) vorgesehen sind, wobei das Messgerät dazu eingerichtet ist, eine durch einen Kondensatoreffekt erzeugte Potentialdifferenz zwischen dem Referenzpotential und dem Potential der elektrisch leitenden Lagen (9) zu messen.

4. Verfahren nach einem der vorhergehenden Ansprüche, **dadurch gekennzeichnet, dass** in Schritt e) die Durchgangsbohrung (12) mit dem weiteren Bohrer erzeugt wird.

5. Verfahren nach einem der Ansprüche 1 bis 3, **dadurch gekennzeichnet, dass** in Schritt e) die Durchgangsbohrung mit einem Bohrer (5) erzeugt wird, dessen Außendurchmesser größer als der des weiteren Bohrers ist.

6. Verfahren nach Anspruch 5, **dadurch gekennzeichnet, dass** in Schritt e) die Position des Bohrers (5) relativ zu dem Referenzpunkt mittels der Tiefenmesseinrichtung bestimmt wird, wenn das Messgerät das Erreichen einer elektrisch leitenden Lage (9) nachfolgend der in Schritt b) erreichten Position detektiert.

7. Verfahren nach einem der vorhergehenden Ansprüche, **dadurch gekennzeichnet, dass** mehrere elektrisch leitende Lagen (9) vorgesehen sind, wobei in Schritt b) der Bohrer (5) bei jedem über das Messgerät detektierten Kontakt stoppt, danach ganz oder teilweise aus dem Bohrloch (13a, 13b) zurückgezogen wird, und danach erneut weitergebohrt wird, wobei bis zum Erreichen der Position, an der der Bohrer (5) zuletzt gestoppt hat, detektierte Kontakte des Messgeräts ignoriert werden.

8. Verfahren nach einem der vorhergehenden Ansprüche, **dadurch gekennzeichnet, dass** mehrere elektrisch leitende Lagen (9) vorgesehen sind, deren Anzahl bekannt ist, wobei die Position des Bohrers (5) relativ zu dem Referenzpunkt mittels der Tiefenmesseinrichtung bestimmt wird, immer wenn das Messgerät das Erreichen einer elektrisch leitenden Lage (9) detektiert.

9. Verfahren nach einem der vorhergehenden Ansprüche, **dadurch gekennzeichnet, dass** die in Schritt d) und/oder die nach Anspruch 6 mittels der Tiefenmesseinrichtung ermittelte Position des Bohrers relativ zu dem Referenzpunkt auf Plausibilität überprüft und ggf. eine korrigierte Position der elektrisch leitenden Lage (9) errechnet wird.

10. Verfahren zur Herstellung einer Tiefenbohrung in einem Sandwichbauteil (6), das mehrere miteinander verbundene Lagen (9, 10) aufweist, von denen wenigstens eine Lage (9) elektrisch leitend ist und die unmittelbar benachbarten Lagen (10) nicht elektrisch leitend sind, wobei die exakte Position der elektrisch leitenden Lage (9) innerhalb des Sandwichbauteil (6) unbekannt ist, mit folgenden Schritten:
i) Ermittlung der Position der wenigstens einen elektrisch leitenden Lage (9) innerhalb des Sandwichbauteils (6) an mehreren voneinander beabstandeten Stellen,
ii) Erzeugen eines virtuellen dreidimensionalen Modells des Sandwichbauteils (6) einschließlich zumindest einer seiner Lagen (9) auf Basis der Ergebnisse aus Schritt i),
iii) Einbringen der Tiefenbohrung auf Basis des in Schritt ii) erzeugten Modells.

11. Verfahren nach Anspruch 10, **dadurch gekennzeichnet, dass** die Position in einem Verfahren nach einem der Ansprüche 1 bis 9 ermittelt wird.

12. Verfahren zur Herstellung einer Tiefenbohrung in einem Sandwichbauteil (6), wobei die Tiefe der Tiefenbohrung relativ zu einer Oberfläche des Sandwichbauteils (6) bekannt ist, mit folgenden Schritten:
Auflegen wenigstens einer unteren Schicht (3) auf einen Tisch (2) einer Bohrmaschine (1), Auflegen des Sandwichbauteils (6) auf die untere Schicht (3), Auflegen wenigstens einer oberen Schicht (7) auf das Sandwichbauteil (6), Messen des Abstands wenigstens eines Referenzpunktes (14) auf der oberen Schicht (7) zu der Oberfläche des Tisches (2), Errechnen der Tiefe der Tiefenbohrung relativ zu dem Referenzpunkt (14) auf der oberen Schicht (7) und Einbringen der Tiefenbohrung bis zu der errechneten Tiefe.

13. Verfahren nach Anspruch 12, **dadurch gekennzeichnet, dass** vor dem Auflegen des Sandwichbauteils (6) die wenigstens eine untere Schicht (3) und die wenigstens eine oberen Schicht (7) auf dem Tisch (2) aufeinandergelegt werden, danach der Abstands wenigstens eines Referenzpunktes (14) auf der oberen Schicht (7) zu der Oberfläche des Tisches (2) gemessen wird, danach das Sandwichbauteils (6) zwischen der unteren Schicht (3) und der oberen Schicht (7) eingelegt und erneut der Abstands wenigstens eines Referenzpunktes (14) auf der oberen Schicht (7) zu der Oberfläche des Tisches (2) gemessen wird, wobei die Tiefe der Tiefenbohrung relativ zu dem Referenzpunkt (14) auf der oberen Schicht (7) unter Berücksichtigung der Messergebnisse vor und nach dem Einlegen des Sandwichbauteils (6) errechnet wird.

14. Verfahren nach Anspruch 12 oder 13, **dadurch gekennzeichnet, dass** die Tiefe der Tiefenbohrung relativ zu einer Oberfläche des Sandwichbauteils (6) zuvor mittels eines Verfahrens nach einem der Ansprüche 1 bis 11 ermittelt wird.

15. Bohrmaschine mit wenigstens einem Bohrer (5), einem mit dem Bohrer (5) verbundenen Messgerät, das über den Bohrer (5) eine Potentialdifferenz zwischen einem Bauteil (6) und einem Referenzpotential misst, einer Tiefenmesseinrichtung, mit der die Position des Bohrers (5) relativ zu einem Referenzpunkt (14) messbar ist, und einer Rechnereinheit, die zum automatisierten Ausführen eines Verfahrens nach einem der vorhergehenden Ansprüche eingerichtet ist.
